(19) **Europäisches Patentamt**
**European Patent Office**
**Office européen des brevets**

(11) **EP 4 760 302 A1**

(12) **EUROPEAN PATENT APPLICATION**
published in accordance with Art. 153(4) EPC

(43) Date of publication:
**17.06.2026 Bulletin 2026/25**

(21) Application number: **25787056.8**

(22) Date of filing: **28.03.2025**

(51) International Patent Classification (IPC):
**G01R 31/382** (2019.01)     **G01R 31/367** (2019.01)
**G01R 31/396** (2019.01)     **G01R 31/36** (2020.01)

(52) Cooperative Patent Classification (CPC):
**G01R 31/36; G01R 31/367; G01R 31/382;**
**G01R 31/396**

(86) International application number:
**PCT/KR2025/004102**

(87) International publication number:
**WO 2025/216464 (16.10.2025 Gazette 2025/42)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **08.04.2024   KR 20240047587**
**27.03.2025   KR 20250039660**

(71) Applicant: **LG Energy Solution, Ltd.**
**Seoul 07335 (KR)**

(72) Inventor: **LEE, Hyun-Chul**
**Daejeon 34122 (KR)**

(74) Representative: **Plasseraud IP**
**104 Rue de Richelieu**
**CS92104**
**75080 Paris Cedex 02 (FR)**

(54) **SOC DETERMINATION APPARATUS AND SOC DETERMINATION METHOD FOR BATTERY BANK**

(57)     Provided are a state of charge (SOC) determination method and an SOC determination apparatus for a battery bank. The SOC determination method according to the present disclosure includes determining a first SOC to be equal to an average SOC of a plurality of battery groups. When the first SOC is different from a reference SOC or is outside of a reference SOC range, the SOC determination method further includes determining a second SOC to be equal to a maximum SOC or a minimum SOC of the plurality of battery groups, and determining an SOC of the battery bank by applying a weighted sum operation to the first SOC and the second SOC.

FIG. 2

**Description**

TECHNICAL FIELD

The present disclosure relates to state of charge (SOC) determination of a battery bank including a plurality of battery groups.

This application is based on and claims priority to Korean Patent Application No. 10-2024-0047587 filed on April 8, 2024 and Korean Patent Application No. 10-2025-0039660 filed on March 27, 2025 in the Republic of Korea, the disclosures of which are incorporated herein by reference.

BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Batteries on the market now include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

More recently, it is important for not only energy storage systems but also electric vehicles to achieve as high capacity as possible for the purpose of stable power management. Accordingly, one of commonly used control method is to selectively connect one or more of a plurality of battery groups that are installed to be connectable either in series or in parallel or both in a battery bank including the plurality of battery groups, according to the amount of power required from the outside.

Extremely high or low state of charge (SOC) may accelerate degradation, cause uneven degradation across the plurality of battery groups, increase explosion risks and significantly decrease the overall charge/discharge performance of the battery bank. Accordingly, it is necessary to control the battery bank to bring the SOC of each battery group to within an optimal SOC range and reduce SOC deviations between the plurality of battery groups.

There may be some differences between the average SOC of the plurality of battery groups and the SOC of the individual battery groups. When the SOC of at least one of the plurality of battery groups is outside of the optimal SOC range, immediately stopping the charging or discharging of the battery bank may prevent the aforementioned problem to some extent.

However, when the average SOC is notified to a user as SOC of the battery bank or is used to control the battery system, even though the average SOC (for example, 98%) is within the optimal SOC range, charging or discharging may be suddenly stopped due to the SOC (for example, 100%) of at least one battery group outside of the optimal SOC range, causing some unexpected inconvenience to the user of the battery bank and posing grave safety threat to the battery system.

DISCLOSURE

Technical Problem

The present disclosure is designed to solve the above-described problems, and therefore the present disclosure is directed to providing an apparatus and method for determining a state of charge (SOC) of a battery bank including a plurality of battery groups as a value that meets charging/discharging operation conditions of the battery bank based on SOC factors (for example, an average SOC, a maximum SOC and/or a minimum SOC) of the plurality of battery groups of the battery bank, rather than the SOC factors.

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

Technical Solution

A state of charge (SOC) determination method for a battery bank including a plurality of battery groups according to an aspect of the present disclosure includes determining a first SOC to be equal to an average SOC of the plurality of battery groups. When the first SOC is different from a reference SOC or is outside of a reference SOC range, the SOC determination method further includes determining a second SOC to be equal to a maximum SOC or a minimum SOC of the plurality of battery groups, depending on whether the battery bank is being charged or discharged, and determining an SOC of the battery bank by applying a weighted sum operation to the first SOC and the second SOC.

The determining of the SOC of the battery bank may include determining a first weight and a second weight based on the second SOC, and determining the SOC of the battery bank by applying the first weight and the second weight to the first SOC and the second SOC, respectively.

When the battery bank is being charged and the first SOC is larger than the reference SOC or an upper limit of the reference SOC range, the determining of the first weight and the second weight may include determining the second weight by applying a predetermined positive correspondence relationship to the second SOC, and determining the first weight as a value whose sum with the second weight is equal to a predetermined set value.

When the battery bank is being discharged and the first SOC is smaller than the reference SOC or a lower limit of the reference SOC range, the determining of the first weight and the second weight may include determining the first weight by applying a predetermined positive correspondence relationship to the second SOC, and determining the second weight as a value whose sum with the first weight is equal to a predetermined set value.

When the battery bank is being charged and the first SOC is larger than the reference SOC or an upper limit of the reference SOC range, the determining of the first weight and the second weight may include determining the first weight by applying a predetermined negative correspondence relationship to the second SOC, and determining the second weight as a value whose sum with the first weight is equal to a predetermined set value.

When the battery bank is being discharged and the first SOC is smaller than the reference SOC or an upper limit of the reference SOC range, the determining of the first weight and the second weight may include determining the second weight by applying a predetermined negative correspondence relationship to the second SOC, and determining the first weight as a value whose sum with the second weight is equal to a predetermined set value.

The SOC determination method may further include determining the SOC of the battery bank to be equal to the first SOC, when the first SOC is equal to the reference SOC or falls within the reference SOC range.

The determining of the second SOC may include determining the second SOC to be equal to the maximum SOC, when the battery bank is being charged, and determining the second SOC to be equal to the minimum SOC, when the battery bank is being discharged.

The SOC determination method may further include stopping the charging or discharging of the battery bank, when the SOC of the battery bank reaches an upper limit or a lower limit of an allowable SOC range or is outside of the allowable SOC range.

An SOC determination method for a battery bank including a plurality of battery groups according to another aspect of the present disclosure includes determining a first SOC to be equal to an average SOC of the plurality of battery groups. When the first SOC is different from a reference SOC or is outside of a reference SOC range, the SOC determination method further includes determining a second SOC to be equal to a maximum SOC or a minimum SOC of the plurality of battery groups, depending on whether the battery bank is being charged or discharged, determining a first weight and a second weight based on the second SOC, determining a third SOC by applying a first weighted sum operation to the first SOC and the second SOC, and determining an SOC of the battery bank by applying a second weighted sum operation to the third SOC and a previous SOC of the battery bank.

The SOC determination method may further include determining the third SOC to be equal to the first SOC, when the first SOC is equal to the reference SOC or falls within the reference SOC range.

The determining of the SOC of the battery bank includes determining a third weight and a fourth weight based on a difference between the third SOC and the previous SOC of the battery bank, and determining the SOC of the battery bank by applying the third weight and the fourth weight to the third SOC and the previous SOC of the battery bank, respectively.

An SOC determination apparatus for a battery bank including a plurality of battery groups according to still another aspect of the present disclosure includes a processor to determine a first SOC to be equal to an average SOC of the plurality of battery groups. When the first SOC is different from a reference SOC or is outside of a reference SOC range, the processor is configured to perform the following operations of: determining a second SOC to be equal to a maximum SOC or a minimum SOC of the plurality of battery groups, depending on whether the battery bank is being charged or discharged, and determining an SOC of the battery bank by applying a weighted sum operation to the first SOC and the second SOC.

An SOC determination apparatus for a battery bank including a plurality of battery groups according to further another aspect of the present disclosure includes a processor to determine a first SOC to be equal to an average SOC of the plurality of battery groups. When the first SOC is different from a reference SOC or is outside of a reference SOC range, the processor is configured to perform the following operations of: determining a second SOC to be equal to a maximum SOC or a minimum SOC of the plurality of battery groups, depending on whether the battery bank is being charged or discharged, determining a third SOC by applying a first weighted sum operation to the first SOC and the second SOC, and determining an SOC of the battery bank by applying a second weighted sum operation to the third SOC and a previous SOC of the battery bank.

A battery system according to yet another aspect of the present disclosure includes the SOC determination apparatus.

Advantageous Effects

According to at least one of the embodiments of the present disclosure, the SOC of the battery bank may be determined as a value that meets the charging/discharging operation conditions of the battery bank by applying a mathematical operation corresponding to the charging/discharging operation conditions of the battery bank to state of charge (SOC) factors (for example, an average SOC, a maximum SOC, and/or a minimum SOC) of the plurality of battery groups included in the battery bank, rather than the SOC factors.

The SOC of the battery bank determined according to the present disclosure may be used to determine whether to stop the charging or discharging of the battery bank instead of the SOC factors, thereby preventing sudden cessation of charging or discharging.

The effects of the embodiments of the present disclosure are not limited to the aforementioned effects, and these and other effects will be clearly understood by those skilled in the art from the appended claims.

BRIEF DESCRIPTION OF THE DRAWINGS

The accompanying drawings illustrate exemplary embodiments of the present disclosure and together with the following detailed description, serve to provide a better understanding of the technical aspects of the present disclosure, and thus the present disclosure should not be construed as being limited to the drawings.

FIG. 1 is a diagram exemplarily showing the architecture of a battery system 1 according to the present disclosure.
FIG. 2 is a flowchart exemplarily showing a state of charge (SOC) determination method according to a first embodiment of the present disclosure.
FIG. 3 is a flowchart schematically illustrating an example of subroutines that may be performed in step S242 of the method of FIG. 2.
FIG. 4 is a diagram referenced in describing the method of FIG. 3.
FIG. 5 is a flowchart schematically illustrating another example of subroutines that may be performed in step S242 of the method of FIG. 2.
FIG. 6 is a diagram referenced in describing the method of FIG. 5.
FIG. 7 is a flowchart schematically illustrating another example of subroutines that may be performed in step S242 of the method of FIG. 2.
FIG. 8 is a flowchart schematically illustrating another example of subroutines that may be performed in step S242 of the method of FIG. 2.
FIG. 9 is a flowchart exemplarily showing an SOC determination method according to a second embodiment of the present disclosure.
FIG. 10 is a flowchart exemplarily showing an SOC determination method according to a third embodiment of the present disclosure.
FIG. 11 is a flowchart exemplarily showing an SOC determination method according to a fourth embodiment of the present disclosure.

BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure but not intended to be limiting, so it should be understood that a variety of other equivalents and modifications could be made thereto at the time the application was filed.

The terms including the ordinal numbers such as "first", "second" and the like, are used to distinguish one element from another among various elements, but not intended to limit the elements by the terms.

Unless the context clearly indicates otherwise, the terms "comprise" and "include" when used in this specification, specify the presence of the stated elements, but do not preclude the presence or addition of one or more other elements. Additionally, the term "unit" as used herein refers to a processing unit of at least one function or operation, and may be implemented by hardware and software either alone or in combination.

In addition, throughout this specification, it will be further understood that when an element is referred to as being "connected to" another element, it can be directly connected to the other element or intervening elements may be present.

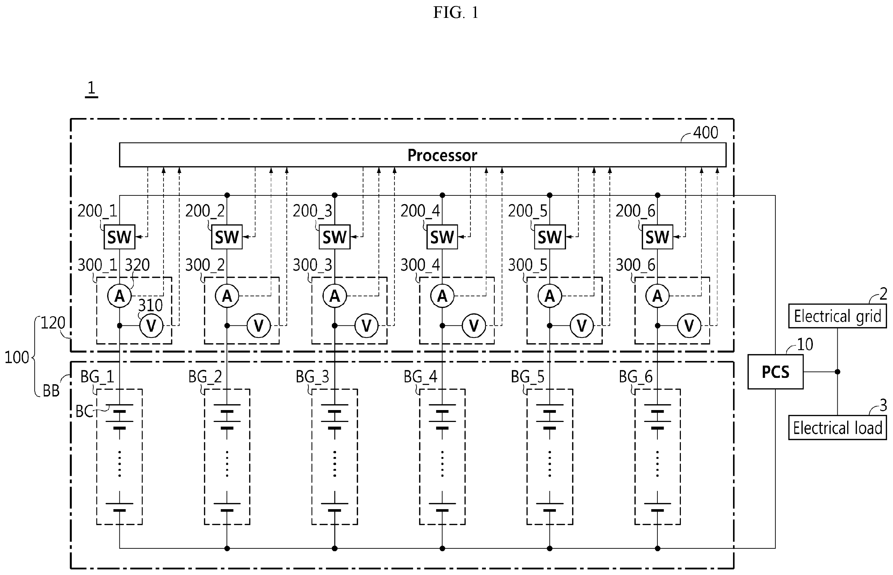

FIG. 1 is a diagram exemplarily showing the architecture of a battery system 1 according to the present disclosure.

Referring to FIG. 1, the battery system 1 includes a battery bank BB, a battery monitoring apparatus 120 and a power conversion system 10.

The power conversion system 10 is electrically connected between the battery bank BB and an electrical grid 2 and/or an electrical load 3.

The power conversion system 10 takes responsibility for power transfer between the battery bank BB and the electrical grid 2 and/or between the battery bank BB and the electrical load 3 using a direct current (DC)-alternating current (AC) inverter and/or a DC-DC converter equipped therein. That is, during operation in a battery charging mode, the power conversion system 10 may convert AC power supplied from the electrical grid 2 to DC power and supply it to the battery bank BB.

In addition, during operation in a battery discharging mode, the power conversion system 10 may convert DC input power by the discharge of the battery bank BB to AC power and supply it to the electrical grid 2 and/or the electrical load 3.

The battery monitoring apparatus 120 may acquire state information of the battery bank BB and transmit a charge command, a discharge command and/or a standby command to the power conversion system 10 based on the acquired state information. In response to the charge command, the power conversion system 10 may operate the DC-AC inverter in the battery charging mode. In response to the discharge command, the power conversion system 10 may operate the DC-AC inverter in the battery discharging mode.

The charge command is a signal that requests DC power supply to the battery bank BB. The discharge command is a signal that requests DC power release from the battery bank BB. The standby command is a signal that requests for stopping the charging operation and the discharging operation.

The battery bank BB includes a plurality of battery groups BG_1~BG_m. m is a natural number of 2 or greater. In this specification, in the description shared between the plurality of battery groups BG_1~BG_m, the symbol 'BG' is affixed to the battery group. The battery group BG may be referred to as 'battery pack' or 'battery rack' depending on the application of use of the battery group BG.

For convenience of description, although FIG. 1 shows m=6, i.e., the battery bank BB including a total of six battery groups BG_1~BG_6, the number of battery groups BG is not limited to a particular number and may be two or more.

The battery group BG includes one battery cell BC or two or more battery cells BC connected in series. In this specification, the battery cell BC refers to the basic unit of a battery and the smallest, self-contained component that can be charged and discharged, and is not limited to a particular type and may include any rechargeable battery, for example, a lithium-ion cell.

When state of charge (SOC) determination methods as described below are performed by the battery monitoring apparatus 120, the battery monitoring apparatus 120 may be referred to as 'SOC determination apparatus'.

The battery monitoring apparatus 120 may be configured to control the charge and discharge of the plurality of battery groups BG_1~BG_m to suppress SOC deviations and/or state of health (SOH) deviations between the plurality of battery groups BG_1~BG_m.

The battery monitoring apparatus 120 includes a processor 400. The battery monitoring apparatus 120 may further include at least one of a plurality of switches 200_1~200_m and a plurality of sensing circuits 300_1~300_m.

The plurality of switches 200_1~200_m are connected in series, respectively, to the plurality of battery groups BG_1~BG_m in a one-to-one relationship. That is, any two or more of the plurality of battery groups BG_1~BG_m may be connected in parallel through the plurality of switches 200_1~200_m.

In this specification, in the description shared between the plurality of switches 200_1~200_m, the symbol '200' is affixed to the switch. The switch 200 is not limited to a particular type and may include any type of switch that turns on and off a current path between the battery group BG and the power conversion system 10. As an example, the switch 200 may include a semiconductor switch such as a metal-oxide-semiconductor field-effect transistor (MOSFET) or a mechanical switch such as a relay. As another example, the switch 200 may include a bidirectional DC-DC converter.

When it is assumed that i is a natural number that is equal to or smaller than m, while the switch 200_i is turned on, the battery group BG_i can be charged and discharged. While the switch 200_i is turned off, the battery group BG_i is electrically separated from other battery groups of the battery bank BB and also electrically separated from the power conversion system 10.

The plurality of sensing circuits 300_1~300_m are provided to the plurality of battery groups BG_1~BG_m, respectively. In this specification, in the description shared between the plurality of sensing circuits 300_1~300_m, the symbol '300' is affixed to the sensing circuit.

The sensing circuit 300 includes a voltage sensor 310 and a current sensor 320. The sensing circuit 300 measures the voltage and current of the connected battery group BG using the voltage sensor 310 and the current sensor 320. The voltage sensor 310 is connected in parallel to the battery group BG and measures the voltage across the battery group BG. The current sensor 320 is installed in a power line connecting the battery group BG to the switch 200 and measures the current flowing through the battery group BG. The sensing circuit 300 generates a sensing signal indicating the measured voltage and the measured current. The sensing signal may indicate a pair of voltage value and current value detected in synchronization.

The processor 400 is individually operably coupled to the plurality of switches 200_1~200_m, the plurality of sensing circuits 300_1~300_m and the power conversion system 10. Here, "operably coupled" refers to connection to enable signal transmission and reception in one or two directions.

The processor 400 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors or electrical units for performing other functions.

The processor 400 may have a memory device. The memory device may include at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory device may store data and programs required for the operation by the processor 400. The memory device may store data indicating the results of the operation by the processor 400.

The processor 400 may periodically collect the sensing signal from each of the plurality of sensing circuits 300_1~300_m. The processor 400 may determine the SOC of each of the plurality of battery groups BG_1~BG_m and additionally determine the SOH, based on the sensing signals.

The SOC indicates a ratio of remaining capacity to maximum capacity and is generally represented as a range between 0% and 100%. The remaining capacity indicates the amount of charge currently stored in the battery group BG.

The SOH indicates a ratio of maximum capacity to design capacity, and is generally represented as a range between 0% and 100%. The design capacity indicates the maximum amount of charge that can be stored in the battery group BG when the battery group BG is fresh. The maximum capacity indicates the maximum amount of charge that can be stored in the battery group BG when the battery group BG degrades from the initial state. As the battery group BG degrades, the maximum capacity gradually declines from the design capacity. Each of SOC and SOH may be estimated from one of various known techniques or a combination thereof, and its detailed description is omitted.

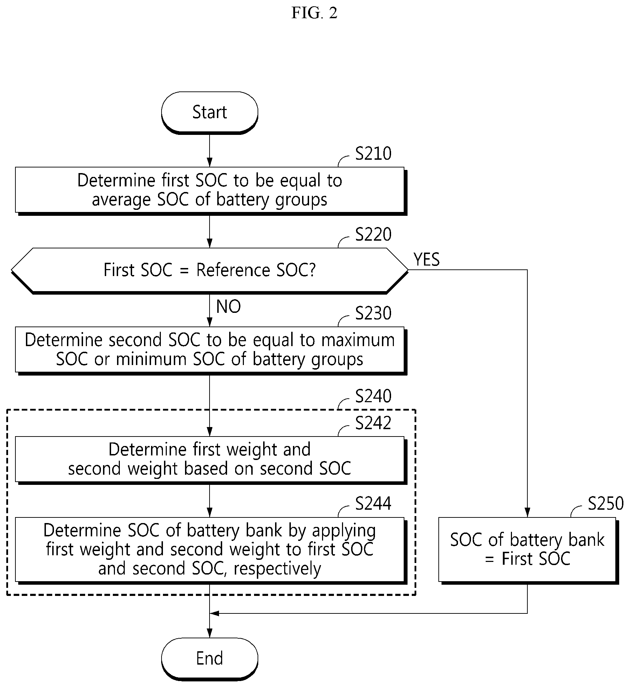

Hereinafter, various embodiments for determining the SOC of the battery bank BB according to the charging/-discharging operation conditions of the battery bank BB will be described with reference to FIGS. 2 to 11. The charging/discharging operation conditions may be the term indicating the operation state of the battery bank BB such as whether the battery bank BB is being charged or discharged, or the SOC of at least one of the plurality of battery groups BG_1~BG_m.

FIG. 2 is a flowchart exemplarily showing the SOC determination method according to a first embodiment of the present disclosure. The method of FIG. 2 may be performed by the battery monitoring apparatus 120 shown in FIG. 1. The battery monitoring apparatus 120 may periodically determine the SOC of each battery group during charging or discharging of the battery bank BB.

Referring to FIGS. 1 and 2, in step S210, the processor 400 determines a first SOC to be equal to the average SOC of the plurality of battery groups BG_1~BG_m. For example, the first SOC may indicate the arithmetic mean or harmonic mean of SOC values of the plurality of battery groups BG_1~BG_m.

In step S220, the processor 400 determines whether the first SOC is equal to a reference SOC. The reference SOC may be preset as a median value (for example, 50%) of a predetermined allowable SOC range (for example, 0% to 100%, or 2% to 98%) of the battery group BG. A value of the step S220 being "NO" indicates that the first SOC is different from the reference SOC. When the value of the step S220 is "NO", step S230 is performed. When the value of the step S220 is "YES", step S250 is performed.

In the step S230, the processor 400 determines a second SOC to be equal to the maximum SOC or minimum SOC of the plurality of battery groups BG_1~BG_m, depending on whether the battery bank BB is being charged or discharged. As an example, when the battery bank BB is being charged, the maximum SOC of the plurality of battery groups BG_1~BG_m may be determined as the second SOC. As another example, when the battery bank BB is being discharged, the minimum SOC of the plurality of battery groups BG_1~BG_m may be determined as the second SOC.

In step S240, the processor 400 determines the SOC of the battery bank BB by applying a weighted sum operation (see Relation equations 1 to 4 as described below) to the first SOC and the second SOC. The step S240 may include step S242 and step S244.

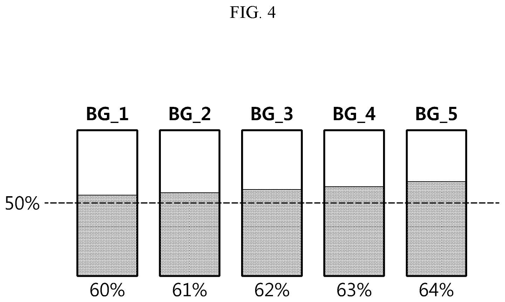

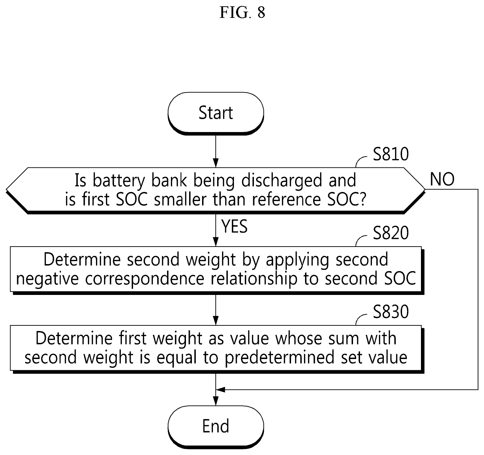

In the step S242, the processor 400 determines a first weight and a second weight based on the second SOC. The first weight may be used for the first SOC, and the second weight may be used for the second SOC. The step S242 will be described with reference to FIGS. 4 and 8 below.

In the step S244, the processor 400 determines the SOC of the battery bank BB by applying the first weight and the second weight to the first SOC and the second SOC, respectively. That is, the SOC of the battery bank BB may indicate the weighted sum of the first SOC and the second SOC using the first weight and the second weight.

In the step S250, the processor 400 determines the SOC of the battery bank BB to be equal to the first SOC. The SOC of the battery bank BB may be, for example, referred to as 'bank SOC', "representative SOC' or 'system SOC'.

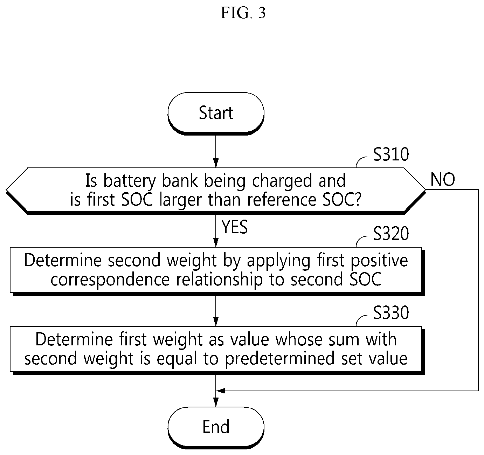

FIG. 3 is a flowchart schematically illustrating an example of subroutines that may be performed in the step S242 of the method of FIG. 2, and FIG. 4 is a diagram referenced in describing the method of FIG. 3.

Referring to FIG. 3, in step S310, the processor 400 determines whether the battery bank BB is being charged and the first SOC is larger than the reference SOC. When the battery bank BB is being discharged or at rest, or the first SOC is smaller than the reference SOC, a value of the step S310 is "NO". When the value of the step S310 is "YES", step S320 is performed. FIG. 4 shows a situation where m = 5 and the first SOC = 62%. When the reference SOC = 50%, the output value of the step S310 is "YES".

In the step S320, the processor 400 determines the second weight by applying a predetermined first positive correspondence relationship to the second SOC (for example, maximum SOC).

The following Relational equation 1 may be an example of the first positive correspondence relationship.

<Relation equation 1>

$$y_A(x) = \sum_{k=1}^{U_A} (A_k \times x^k) + A_0$$

In Relation equation 1, x denotes the second SOC, $U_A$ denotes a preset positive integer, $A_k$ denotes a predetermined k-th coefficient corresponding to the index k, $A_0$ denotes a preset positive number (for example, 0.5) that is equal to or larger than a reference value corresponding to the reference SOC, and $y_A(x)$ denotes the second weight. The maximum value of $y_A(x)$ may be limited to a predetermined set value (for example, 1).

The first positive correspondence relationship is not limited to Relation equation 1. When the second SOC is between the reference SOC and the upper limit of the allowable SOC range, any mathematical operation other than Relation equation 1, which makes the second weight larger with the increasing second SOC may be used for the first positive correspondence relationship.

In step S330, the processor 400 determines the first weight as a value whose sum with the second weight determined in the step S320 is equal to the set value. That is, Second weight = Set value - First weight.

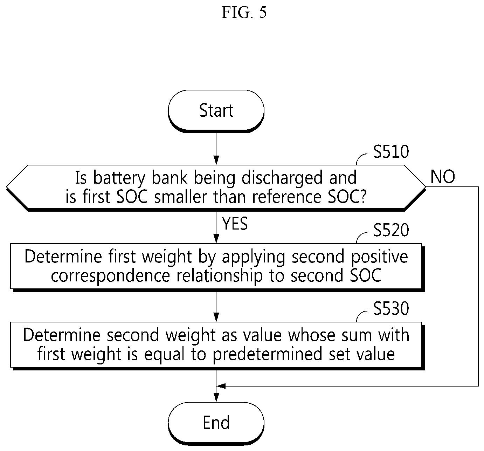

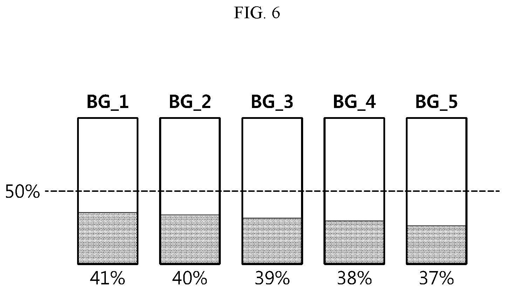

FIG. 5 is a flowchart schematically illustrating another example of subroutines that may be performed in the step S242 of the method of FIG. 2, and FIG. 6 is a diagram referenced in describing the method of FIG. 5.

Referring to FIG. 5, in step S510, the processor 400 determines whether the battery bank BB is being discharged and the first SOC is smaller than the reference SOC. When the battery bank BB is being charged or at rest, or the first SOC is larger than the reference SOC, a value of the step S510 is "NO". When the value of the step S510 is "YES", step S520 is performed. FIG. 6 shows a situation where m = 5 and the first SOC = 39%. When the reference SOC = 50%, the output value of the step S510 is "YES".

In the step S520, the processor 400 determines the first weight by applying a predetermined second positive correspondence relationship to the second SOC (for example, minimum SOC).

The following Relation equation 2 may be an example of the second positive correspondence relationship.

<Relation equation 2>

$$y_B(x) = \sum_{k=1}^{U_B} (B_k \times x^k) + B_0$$

In Relation equation 2, x denotes the second SOC, $U_B$ denotes a preset positive integer, $B_k$ denotes a predetermined k-th coefficient corresponding to the index k, $B_0$ denotes a preset constant that is smaller than the reference value, and $y_B(x)$ denotes the first weight. The maximum value of $y_B(x)$ may be limited to the reference value. $B_0$ may be equal to a ratio value (for example, 0, 0.02) corresponding to the lower limit (for example, 0%, 2%) of the allowable SOC range.

The second positive correspondence relationship is not limited to Relation equation 2. When the second SOC is between the lower limit of the allowable SOC range and the reference value, any mathematical operation other than Relation equation 2, which makes the first weight smaller with the decreasing second SOC may be used for the second positive correspondence relationship.

In step S530, the processor 400 determines the second weight as a value whose sum with the first weight determined in the step S520 is equal to the predetermined set value. That is, Second weight = Set value - First weight. Because the second positive correspondence relationship makes the first weight smaller with the decreasing second SOC, as the second SOC is smaller, the second weight determined in the step S530 may be larger.

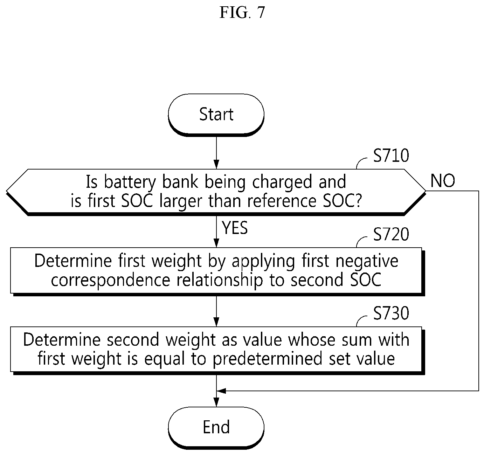

FIG. 7 is a flowchart schematically illustrating another example of subroutines that may be performed in the step S242 of the method of FIG. 2. To help understanding, in describing the method of FIG. 7, reference may be made to FIG. 4 again.

Referring to FIG. 7, in step S710, the processor 400 determines whether the battery bank BB is being charged and the first SOC is larger than the reference SOC. When a value of the step S710 is "YES", step S720 is performed.

In the step S720, the processor 400 determines the first weight by applying a predetermined first negative correspondence relationship to the second SOC (for example, maximum SOC).

The following Relation equation 3 may be an example of the first negative correspondence relationship.

<Relation equation 3>

$$y_C(x) = C_0 - \sum_{k=1}^{U_C} (C_k \times x^k)$$

In Relation equation 3, x denotes the second SOC, $U_C$ denotes a preset positive integer, $C_k$ denotes a predetermined k-th coefficient corresponding to the index k, $C_0$ denotes a preset constant (for example, equal to the reference value), and $y_C(x)$ denotes the first weight. The maximum value of $y_C(x)$ may be limited to the reference value.

The first negative correspondence relationship is not limited to Relation equation 3. When the second SOC is between the lower limit of the allowable SOC range and the reference value, any mathematical operation other than Relation equation 3, which makes the first weight smaller with the increasing second SOC may be used for the first negative correspondence relationship.

In step S730, the processor 400 determines the second weight as a value whose sum with the first weight determined in the step S720 is equal to the predetermined set value. Because the first negative correspondence relationship makes the first weight smaller with the increasing second SOC, as the second SOC is larger, the second weight determined in the step S730 may be larger.

FIG. 8 is a flowchart schematically illustrating another example of subroutines that may be performed in the step S242 of the method of FIG. 2. In describing the method of FIG. 8, reference may be made to FIG. 6 again.

Referring to FIG. 8, in step S810, the processor 400 determines whether the battery bank BB is being discharged and the first SOC is smaller than the reference SOC. When a value of the step S810 is "YES", step S820 is performed.

In the step S820, the processor 400 determines the second weight by applying a predetermined second negative correspondence relationship to the second SOC (for example, minimum SOC).

The following Relation equation 4 may be an example of the second negative correspondence relationship.

<Relation equation 4>

$$y_D(x) = D_0 - \sum_{k=1}^{U_D} (D_k \times x^k)$$

In Relation equation 4, x denotes the second SOC, $U_D$ denotes a preset positive integer, $D_k$ denotes a predetermined k-th coefficient corresponding to the index k, $D_0$ denotes a preset constant (for example, equal to a set value), and $y_D(x)$ denotes the second weight. The maximum value of $y_D(x)$ may be limited to the set value.

The second negative correspondence relationship is not limited to Relation equation 4. When the second SOC is between the reference value and the lower limit of the allowable SOC range, any mathematical operation other than Relation equation 4, which makes the second weight larger with the decreasing second SOC may be used for the second negative correspondence relationship.

In step S830, the processor 400 determines the first weight as a value whose sum with the second weight determined in the step S820 is equal to the predetermined set value. Because the second negative correspondence relationship makes the second weight larger with the decreasing second SOC, as the second SOC is smaller, the first weight determined in the step S830 may be smaller.

When the value of the step S310 in FIG. 3, the value of the step S510 in FIG. 6, the value of the step S710 in FIG. 7 or the value of the step S810 in FIG. 8 is "NO", the step S250 of FIG. 2 may be performed.

When the first weight and the second weight are determined through the method of FIG. 3, FIG. 5, FIG. 7 or FIG. 8, the SOC of the battery bank BB determined in the step S244 of FIG. 2 may satisfy the following Relation equation 5.

<Relation equation 5>

$$SOC_{Bank} = \left(SOC_{1\_G} \times w_1\right) + \left(SOC_{2\_G} \times w_2\right)$$

In Relation equation 5, $SOC_{Bank}$ is the SOC of the battery bank BB, $SOC_{1\_G}$ is the first SOC, $SOC_{2\_G}$ is the second SOC, $w_1$ is the first weight, and $w_2$ is the second weight.

According to the foregoing, in a situation where the battery bank BB is being charged, the SOC of the battery bank BB may be determined to be equal to the upper limit of the allowable SOC range before or at the time when the second SOC reaches the upper limit of the allowable SOC range. Accordingly, it may be possible to prevent a situation where the SOC of at least one battery group reaches the upper limit of the allowable SOC range before the average SOC reaches the upper limit of the allowable SOC range, thereby automatically avoiding sudden cessation of charging of the battery bank BB.

In a situation where the battery bank BB is being discharged, the SOC of the battery bank BB may be determined to be equal to the lower limit of the allowable SOC range before or at the time when the second SOC reaches the lower limit of the allowable SOC range. Accordingly, it may be possible to prevent a situation where the SOC of at least one battery group reaches the lower limit of the allowable SOC range before the average SOC reaches the lower limit of the allowable SOC range, thereby automatically avoiding sudden cessation of discharging of the battery bank BB.

For reference, $w_1$ and $w_2$ may be obtained as a result of performing any one of FIGS. 3, 5, 7 and 8. That is, a combination of the first weight obtained by any one of the four methods according to FIGS. 3, 5, 7 and 8 and the second weight obtained by any one of the remaining three methods may not be used as $w_1$ and $w_2$ of Relation equation 5.

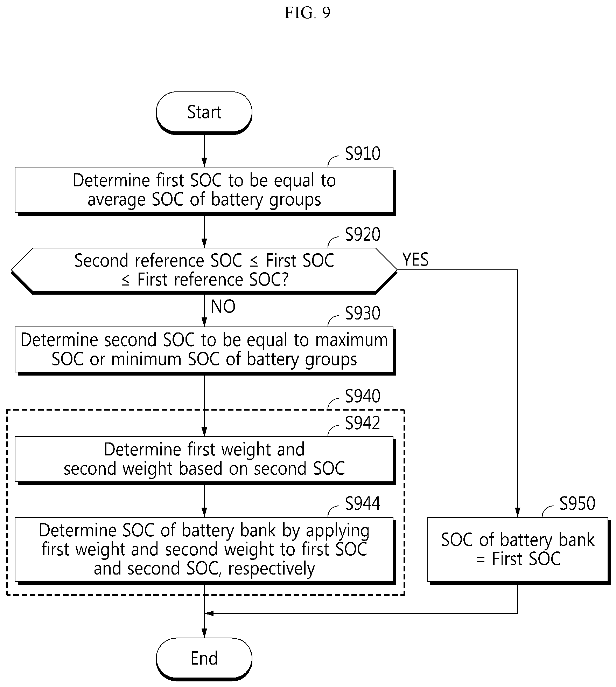

FIG. 9 is a flowchart exemplarily showing the SOC determination method according to a second embodiment of the present disclosure. The method of FIG. 9 may be performed by the battery monitoring apparatus 120 shown in FIG. 1. The battery monitoring apparatus 120 may periodically determine the SOC of each battery group during charging of the battery bank BB.

Referring to FIGS. 1 and 9, in step S910, the processor 400 determines the first SOC to be equal to the average SOC of the plurality of battery groups BG_1~BG_m.

In step S920, the processor 400 determines whether the first SOC is within a reference SOC range. The reference SOC range may be preset to be narrower than the preset allowable SOC range for the battery group BG. The upper limit of the reference SOC range may be referred to as a first reference SOC (for example, 60%), and the lower limit of the reference SOC range may be referred to as a second reference SOC (for example, 40%). That is, when the first SOC is equal to or smaller than the first reference SOC and is equal to or larger than the second reference SOC, a value of the step S920 is "YES". When the value of the step S920 is "NO", step S930 is performed. When the value of the step S920 is "YES", step S950 is performed.

In the step S930, the processor 400 determines the second SOC to be equal to the maximum SOC or minimum SOC of the plurality of battery groups BG_1~BG_m, depending on whether the battery bank BB is being charged or discharged.

In the step S940, the processor 400 determines the SOC of the battery bank BB by applying the weighted sum operation to the first SOC and the second SOC. The step S940 may include step S942 and step S944.

In the step S942, the processor 400 determines the first weight and the second weight. The first weight may be used for the first SOC, and the second weight may be used for the second SOC.

In the step S944, the processor 400 determines the SOC of the battery bank BB by applying the first weight and the second weight to the first SOC and the second SOC, respectively.

In the step S950, the processor 400 determines the SOC of the battery bank BB to be equal to the first SOC.

Meanwhile, the description of the first embodiment made with reference to FIGS. 3 to 8 may be equally applied to the step S942 according to the second embodiment described above with reference to FIG. 9 on the condition that the following modifications are applied.

The modification necessary to apply the method of FIGS. 3 and 7 to the step S942 of FIG. 9 may be a replacement of the 'reference SOC' and the 'reference value' described with reference to FIGS. 3 and 7 with 'first reference SOC' and 'first reference value', respectively. Here, the first reference value may be a ratio value between 0 and 1 corresponding to the first reference SOC. For example, when the first reference SOC is 60%, the first reference value may be 0.6.

The modification necessary to apply the method of FIGS. 5 and 8 to the step S942 of FIG. 9 may be a replacement of the 'reference SOC' and the 'reference value ' described with reference to FIGS. 5 and 8 with 'second reference SOC' and 'second reference value', respectively. Here, the second reference value may be a ratio value between 0 and 1 corresponding to the second reference SOC. For example, when the second reference SOC is 40%, the first reference value may be 0.4.

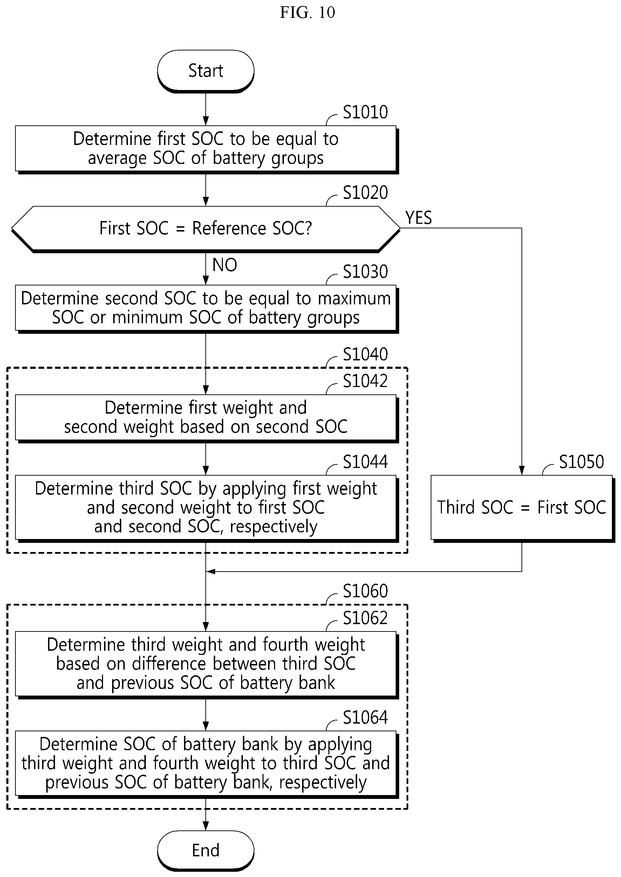

FIG. 10 is a flowchart exemplarily showing the SOC determination method according to a third embodiment of the present disclosure. The method of FIG. 10 may be performed by the battery monitoring apparatus 120 shown in FIG. 1. The battery monitoring apparatus 120 may periodically determine the SOC of each battery group during charging or discharging of the battery bank BB.

Referring to FIGS. 1 and 10, in step S1010, the processor 400 determines the first SOC to be equal to the average SOC of the plurality of battery groups BG_1~BG_m.

In step S1020, the processor 400 determines whether the first SOC is equal to the reference SOC. When a value of the step S1020 is "NO", step S1030 is performed. When the value of the step S1020 is "YES", step S1050 is performed.

In the step S1030, the processor 400 determines the second SOC to be equal to the maximum SOC or minimum SOC of the plurality of battery groups BG_1~BG_m, depending on whether the battery bank BB is being charged or discharged.

In step S1040, the processor 400 determines a third SOC by applying a first weighted sum operation to the first SOC and the second SOC. The step S1040 may include step S1042 and step S1044.

In the step S1042, the processor 400 determines the first weight and the second weight based on the second SOC.

The steps S1010, S1020, S1030 and S1042 of FIG. 10 may be substantially the same as the steps S210, S220, S230 and S242 of FIG. 2, respectively.

In the step S1044, the processor 400 determines the third SOC by applying the first weight and the second weight to the first SOC and the second SOC, respectively. The third SOC may be equal to the SOC of the battery bank BB determined by the step S244. That is, Relation equation 5 may be used as the first weighted sum operation in the step S1040, and in this case, $SOC_{Bank}$ in Relation equation 5 indicates the third SOC that is a temporary SOC before the SOC of the battery bank BB is determined.

In the step S1050, the processor 400 determines the third SOC to be equal to the first SOC.

In step S1060, the processor 400 determines the SOC of the battery bank BB by applying a second weighted sum operation to the third SOC and the previous SOC of the battery bank BB. Because the SOC of the battery bank BB is updated periodically, the SOC of the battery bank BB determined in the previous cycle by the method according to FIG. 10 may be used as the previous SOC in step S1062.

The step S1060 may include the step S1062 and step S1064.

In the step S1062, the processor 400 determines a third weight and a fourth weight based on a difference between the third SOC and the previous SOC of the battery bank BB. The sum of the third weight and the fourth weight may be equal to the set value.

The processor 400 may determine the third weight by applying a predetermined third positive correspondence relationship to the difference (may be an absolute value) between the third SOC and the previous SOC of the battery bank BB, (i) when the battery bank BB is being charged and the third SOC is larger than the previous SOC of the battery bank BB, or (ii) when the battery bank BB is being discharged and the third SOC is smaller than the previous SOC of the battery bank BB. In this instance, the fourth weight may be determined to be equal to a value obtained by subtracting the third weight determined using the third positive correspondence relationship from the set value. The following Relation equation 6 may be an example of the third positive correspondence relationship.

<Relation equation 6>

$$y_E(x) = \sum_{k=1}^{U_E} (E_k \times |x|^k) + E_0 = \sum_{k=1}^{U_E} \left( E_k \times \left| SOC_{3\_G} - SOC_{Bank\_prv} \right|^k \right) + E_0$$

In Relation equation 6, $SOC_{3\_G}$ denotes the third SOC, $SOC_{Bank\_prv}$ denotes the previous SOC of the battery bank BB, x denotes the difference between the third SOC and the previous SOC, $U_E$ denotes a preset positive integer, and $E_k$ denotes a predetermined k-th coefficient corresponding to the index k. $y_E(x)$ denotes the third weight. $E_0$ may be a preset positive number (for example, 1/2 of the set value) that is smaller than the set value. The minimum value of $y_E(x)$ may be limited to $E_0$. The maximum value of $y_E(x)$ may be limited to a first threshold. The first threshold may be a preset value that is equal to or smaller than the set value. That is, when $y_E(x)$ calculated using the third positive correspondence relationship is larger than the first threshold, the third weight may be determined to be equal to the first threshold.

Alternatively, the processor 400 may determine the fourth weight by applying a predetermined third negative correspondence relationship to the difference (which may be an absolute value) between the third SOC and the previous SOC of the battery bank BB, (i) when the battery bank BB is being charged and the third SOC is larger than the previous SOC of the battery bank BB, or (ii) when the battery bank BB is being discharged and the third SOC is smaller than the previous SOC of the battery bank BB. In this case, the third weight may be determined to be equal to a value obtained by subtracting the fourth weight determined using the third negative correspondence relationship from the set value. The following Relation equation 7 may be an example of the third negative correspondence relationship.

<Relation equation 7>

$$y_F(x) = F_0 - \sum_{k=1}^{U_F} (F_k \times |x|^k)$$

In Relation equation 7, $U_F$ denotes a preset positive integer, $F_k$ denotes a predetermined k-th coefficient corresponding to the index k, $y_F(x)$ denotes the fourth weight, and $F_0$ denotes a preset positive number (for example, 1/2 of the set value) that is smaller than the set value. x in Relation equation 7 may be equal to that of Relation equation 6. The minimum value of $y_F(x)$ may be limited to a second threshold. The second threshold may be a preset positive number that is smaller than $F_0$. That is, when $y_F(x)$ calculated using the third positive correspondence relationship is smaller than the second threshold, the fourth weight may be determined to be equal to the second threshold.

In step S1064, the processor 400 determines the SOC of the battery bank BB by applying the third weight and the fourth weight to the third SOC and the previous SOC of the battery bank BB, respectively.

The following Relationship equation 8 is an example of the second weighted sum operation that may be used in the step S1060.

<Relation equation 8>

$$SOC_{Bank} = (SOC_{3\_G} \times w_3) + (SOC_{Bank\_prv} \times w_4)$$

In Relation equation 8, $SOC_{Bank}$ denotes the SOC of the battery bank BB, $SOC_{3\_G}$ denotes the third SOC, and $SOC_{Bank\_prv}$ denotes the previous SOC of the battery bank BB. $w_3$ is the third weight, and $w_4$ is the fourth weight.

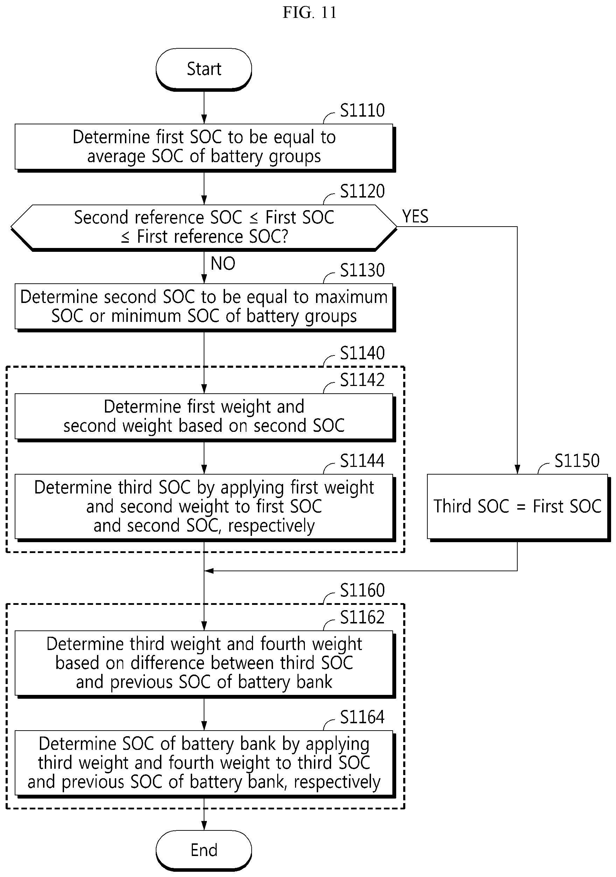

FIG. 11 is a flowchart exemplarily showing the SOC determination method according to a fourth embodiment of the present disclosure. The method of FIG. 11 may be performed by the battery monitoring apparatus 120 shown in FIG. 1. The battery monitoring apparatus 120 may periodically determine the SOC of each battery group during charging or discharging of the battery bank BB.

Referring to FIGS. 1 and 11, in step S1110, the processor 400 determines the first SOC to be equal to the average SOC of the plurality of battery groups BG_1~BG_m.

In step S1120, the processor 400 determines whether the first SOC is within the reference SOC range. That is, when the first SOC is equal to or smaller than the first reference SOC and is equal to or larger than the second reference SOC, a value of the step S1120 is "YES". When the value of the step S1120 is "NO", step S1130 is performed. When the value of the step S1120 is "YES", step S1150 is performed.

In the step S1130, the processor 400 determines the second SOC to be equal to the maximum SOC or minimum SOC of the plurality of battery groups BG_1~BG_m, depending on whether the battery bank BB is being charged or discharged.

In step S1140, the processor 400 determines the third SOC by applying the first weighted sum operation (see the above Relation equations 1 to 4) to the first SOC and the second SOC. The step S1140 may include step S1142 and step S1144.

In the step S1142, the processor 400 determines the first weight and the second weight based on the second SOC.

The steps S1110, S1120, S1130 and S1142 of FIG. 11 may be substantially the same as the steps S910, S920, S930 and S942 of FIG. 9, respectively.

In the step S1144, the processor 400 determines the third SOC by applying the first weight and the second weight to the first SOC and the second SOC, respectively. The third SOC may be equal to the SOC of the battery bank BB determined by the step S944.

In the step S1150, the processor 400 determines the third SOC to be equal to the first SOC.

In step S1160, the processor 400 determines the SOC of the battery bank BB by applying the second weighted sum operation to the third SOC and the previous SOC of the battery bank BB. The step S1160 may include step S1162 and step S1164.

In the step S1162, the processor 400 determines the third weight and the fourth weight based on the difference between the third SOC and the previous SOC of the battery bank BB. The sum of the third weight and the fourth weight may be equal to the set value.

In the step S1164, the processor 400 determines the SOC of the battery bank BB by applying the third weight and the fourth weight to the third SOC and the previous SOC of the battery bank BB, respectively.

The steps S1162 and S1164 of FIG. 11 may be the same as the steps S1062 and S1064 of FIG. 10, respectively.

The processor 400 may determine whether to stop the charging or discharge of the battery bank BB based on the SOC of the battery bank BB determined in the step S240, S940, S1060 or S1160.

Specifically, when the SOC of the battery bank BB reaches the upper limit or lower limit of the allowable SOC range or is outside of the allowable SOC range, the processor 400 may stop the charging or discharging of the battery bank BB. Accordingly, the battery groups BG_1~BG_m of the battery bank BB may be protected from overcharging and overdischarging.

As an example, when the SOC of the battery bank BB reaches the upper limit of the allowable SOC range during charging of the battery bank BB, the processor 400 may transmit the standby command to the power conversion system 10 or turn off the plurality of switches 200_1~200_m.

As another example, when the SOC of the battery bank BB reaches the lower limit of the allowable SOC range during discharging of the battery bank BB, the processor 400 may transmit the standby command to the power conversion system 10 or turn off the plurality of switches 200_1~200_m.

The embodiments of the present disclosure described hereinabove are not realized only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspects of the present disclosure and the scope of the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

**Claims**

1. A state of charge (SOC) determination method for a battery bank including a plurality of battery groups, the SOC determination method comprising:

   determining a first SOC to be equal to an average SOC of the plurality of battery groups,
   wherein the SOC determination method further comprises:

   when the first SOC is different from a reference SOC or is outside of a reference SOC range,
   determining a second SOC to be equal to a maximum SOC or a minimum SOC of the plurality of battery groups, depending on whether the battery bank is being charged or discharged; and
   determining an SOC of the battery bank by applying a weighted sum operation to the first SOC and the second SOC.

2. The SOC determination method according to claim 1,
   wherein the determining of the SOC of the battery bank comprises:

   determining a first weight and a second weight based on the second SOC; and
   determining the SOC of the battery bank by applying the first weight and the second weight to the first SOC and the second SOC, respectively.

3. The SOC determination method according to claim 2,
   wherein the determining of the first weight and the second weight comprises:

   when the battery bank is being charged and the first SOC is larger than the reference SOC or an upper limit of the reference SOC range,
   determining the second weight by applying a predetermined positive correspondence relationship to the second SOC; and
determining the first weight as a value whose sum with the second weight is equal to a predetermined set value.

4. The SOC determination method according to claim 2,
wherein the determining of the first weight and the second weight comprises:

when the battery bank is being discharged and the first SOC is smaller than the reference SOC or a lower limit of the reference SOC range,
determining the first weight by applying a predetermined positive correspondence relationship to the second SOC; and
determining the second weight as a value whose sum with the first weight is equal to a predetermined set value.

5. The SOC determination method according to claim 2,
wherein the determining of the first weight and the second weight comprises:

when the battery bank is being charged and the first SOC is larger than the reference SOC or an upper limit of the reference SOC range,
determining the first weight by applying a predetermined negative correspondence relationship to the second SOC; and
determining the second weight as a value whose sum with the first weight is equal to a predetermined set value.

6. The SOC determination method according to claim 2,
wherein the determining of the first weight and the second weight comprises:

when the battery bank is being discharged and the first SOC is smaller than the reference SOC or an upper limit of the reference SOC range,
determining the second weight by applying a predetermined negative correspondence relationship to the second SOC; and
determining the first weight as a value whose sum with the second weight is equal to a predetermined set value.

7. The SOC determination method according to claim 2, further comprising:
determining the SOC of the battery bank to be equal to the first SOC, when the first SOC is equal to the reference SOC or falls within the reference SOC range.

8. The SOC determination method according to claim 1,
wherein the determining of the second SOC comprises:

determining the second SOC to be equal to the maximum SOC, when the battery bank is being charged, and
determining the second SOC to be equal to the minimum SOC, when the battery bank is being discharged.

9. The SOC determination method according to claim 1, further comprising:
stopping the charging or discharging of the battery bank, when the SOC of the battery bank reaches an upper limit or a lower limit of an allowable SOC range or is outside of the allowable SOC range.

10. A state of charge (SOC) determination method for a battery bank including a plurality of battery groups, the SOC determination method comprising:

determining a first SOC to be equal to an average SOC of the plurality of battery groups,
wherein the SOC determination method further comprises:

when the first SOC is different from a reference SOC or is outside of a reference SOC range,
determining a second SOC to be equal to a maximum SOC or a minimum SOC of the plurality of battery groups, depending on whether the battery bank is being charged or discharged;
determining a first weight and a second weight based on the second SOC; determining a third SOC by applying a first weighted sum operation to the first SOC and the second SOC; and
determining an SOC of the battery bank by applying a second weighted sum operation to the third SOC and a previous SOC of the battery bank.

**11.** The SOC determination method according to claim 10, further comprising:
determining the third SOC to be equal to the first SOC, when the first SOC is equal to the reference SOC or falls within the reference SOC range.

**12.** The SOC determination method according to claim 10,
wherein the determining of the SOC of the battery bank comprises:

determining a third weight and a fourth weight based on a difference between the third SOC and the previous SOC of the battery bank; and
determining the SOC of the battery bank by applying the third weight and the fourth weight to the third SOC and the previous SOC of the battery bank, respectively.

**13.** A state of charge (SOC) determination apparatus for a battery bank including a plurality of battery groups, the SOC determination apparatus comprising:

a processor to determine a first SOC to be equal to an average SOC of the plurality of battery groups,
wherein the processor is configured to perform the following operations of:

when the first SOC is different from a reference SOC or is outside of a reference SOC range,
determining a second SOC to be equal to a maximum SOC or a minimum SOC of the plurality of battery groups, depending on whether the battery bank is being charged or discharged; and
determining an SOC of the battery bank by applying a weighted sum operation to the first SOC and the second SOC.

**14.** A state of charge (SOC) determination apparatus for a battery bank including a plurality of battery groups, the SOC determination apparatus comprising:

a processor to determine a first SOC to be equal to an average SOC of the plurality of battery groups,
wherein the processor is configured to perform the following operations of:

when the first SOC is different from a reference SOC or is outside of a reference SOC range,
determining a second SOC to be equal to a maximum SOC or a minimum SOC of the plurality of battery groups, depending on whether the battery bank is being charged or discharged;
determining a third SOC by applying a first weighted sum operation to the first SOC and the second SOC; and
determining an SOC of the battery bank by applying a second weighted sum operation to the third SOC and a previous SOC of the battery bank.

**15.** A battery system comprising the SOC determination apparatus according to claim 13 or 14.

EP 4 760 302 A1

FIG. 1

15

EP 4 760 302 A1

FIG. 2

Start

Determine first SOC to be equal to
average SOC of battery groups — S210

First SOC = Reference SOC? — S220
— YES

NO

Determine second SOC to be equal to maximum
SOC or minimum SOC of battery groups — S230

S240

Determine first weight and
second weight based on second SOC — S242

Determine SOC of battery bank by applying
first weight and second weight to first SOC
and second SOC, respectively — S244

SOC of battery bank
= First SOC — S250

End

16

FIG. 3

```
                    ┌─────────────┐
                    │    Start    │
                    └──────┬──────┘
                           │
                           ▼                        ⌐ S310
        ╱─────────────────────────────────────────╲
       ╱       Is battery bank being charged and    ╲    NO
       ╲     is first SOC larger than reference SOC? ╱────────┐
        ╲─────────────────────────────────────────╱          │
                        │ YES                                 │
                        ▼              ⌐ S320                 │
        ┌───────────────────────────────────────────┐        │
        │ Determine second weight by applying first  │        │
        │  positive correspondence relationship to   │        │
        │               second SOC                   │        │
        └───────────────────────┬───────────────────┘        │
                                │           ⌐ S330            │
        ┌───────────────────────┼───────────────────┐        │
        │ Determine first weight as value whose sum  │        │
        │  with second weight is equal to            │        │
        │         predetermined set value            │        │
        └───────────────────────┬───────────────────┘        │
                                │◄───────────────────────────┘
                                ▼
                    ┌─────────────┐
                    │     End     │
                    └─────────────┘
```

FIG. 4

FIG. 5

```
                        ┌─────────────┐
                        │    Start    │
                        └──────┬──────┘
                               │              ╭ S510
          ┌────────────────────▼─────────────────────┐
          │    Is battery bank being discharged and   │   NO
          ◁    is first SOC smaller than reference SOC?▷─────┐
          └────────────────────┬─────────────────────┘       │
                               │ YES         ╭ S520           │
          ┌────────────────────▼─────────────────────┐       │
          │  Determine first weight by applying second positive│
          │  correspondence relationship to second SOC │      │
          └────────────────────┬─────────────────────┘       │
                               │             ╭ S530           │
          ┌────────────────────▼─────────────────────┐       │
          │ Determine second weight as value whose sum with│   │
          │  first weight is equal to predetermined set value│  │
          └────────────────────┬─────────────────────┘       │
                               │◄──────────────────────────────┘
                        ┌──────▼──────┐
                        │     End     │
                        └─────────────┘
```

FIG. 6

FIG. 7

```
                    ┌──────────────┐
                    │    Start     │
                    └──────┬───────┘
                           │                    ┌─ S710
        ┌──────────────────▼──────────────────┐     NO
       ◇   Is battery bank being charged and    ◇──────┐
        │  is first SOC larger than reference SOC? │   │
        └──────────────────┬──────────────────┘       │
                           │ YES        ┌─ S720        │
        ┌──────────────────▼──────────────────┐        │
        │ Determine first weight by applying first negative │
        │  correspondence relationship to second SOC │       │
        └──────────────────┬──────────────────┘        │
                           │            ┌─ S730         │
        ┌──────────────────▼──────────────────┐        │
        │ Determine second weight as value whose sum with │
        │  first weight is equal to predetermined set value │
        └──────────────────┬──────────────────┘        │
                           │◄──────────────────────────┘
                    ┌──────▼───────┐
                    │     End      │
                    └──────────────┘
```

FIG. 8

```
                          ┌─────────────┐
                          │    Start    │
                          └──────┬──────┘
                                 │                    S810
                                 ▼
         ╱─────────────────────────────────────────╲      NO
        ╱  Is battery bank being discharged and      ╲────────┐
        ╲  is first SOC smaller than reference SOC?   ╱        │
         ╲─────────────────────┬─────────────────────╱         │
                               │ YES                           │
                               │              S820             │
                               ▼                               │
        ┌──────────────────────────────────────────────┐      │
        │  Determine second weight by applying second    │      │
        │  negative correspondence relationship to       │      │
        │  second SOC                                     │      │
        └──────────────────────┬───────────────────────┘      │
                               │              S830             │
                               ▼                               │
        ┌──────────────────────────────────────────────┐      │
        │  Determine first weight as value whose sum     │      │
        │  with second weight is equal to predetermined  │      │
        │  set value                                     │      │
        └──────────────────────┬───────────────────────┘      │
                               │                               │
                               ▼◄──────────────────────────────┘
                          ┌─────────────┐
                          │     End     │
                          └─────────────┘
```

FIG. 9

```
                    ┌─────────────┐
                    │    Start    │
                    └──────┬──────┘
                           │                    ┌ S910
            ┌──────────────▼──────────────────┐
            │   Determine first SOC to be equal to  │
            │     average SOC of battery groups     │
            └──────────────┬──────────────────┘
                           │                    ┌ S920
          ╱────────────────▼────────────────────╲       YES
         ╱  Second reference SOC ≤ First SOC      ╲──────────┐
         ╲        ≤ First reference SOC?          ╱          │
          ╲────────────────┬────────────────────╱           │
                          NO│          ┌ S930                │
            ┌──────────────▼──────────────────┐              │
            │ Determine second SOC to be equal to maximum │   │
            │    SOC or minimum SOC of battery groups      │   │
            └──────────────┬──────────────────┘              │
                           │         ┌ S940                  │
         ┌─ ─ ─ ─ ─ ─ ─ ─ ─▼─ ─ ─ ─ ─ ─ ─ ─ ─ ┐             │
         │                           ┌ S942     │             │
         │ ┌───────────────────────────────┐   │             │
         │ │      Determine first weight and   │  │           │
         │ │  second weight based on second SOC │  │          │
         │ └──────────────┬────────────────┘   │             │
         │                │        ┌ S944       │     ┌ S950   │
         │ ┌──────────────▼────────────────┐   │  ┌───────────▼──────┐
         │ │ Determine SOC of battery bank by applying │ │ SOC of battery bank │
         │ │first weight and second weight to first SOC │ │   = First SOC    │
         │ │   and second SOC, respectively   │  │  └────────┬─────────┘
         │ └──────────────┬────────────────┘   │            │
         └─ ─ ─ ─ ─ ─ ─ ─ ┼ ─ ─ ─ ─ ─ ─ ─ ─ ─ ┘            │
                          │◄─────────────────────────────────┘
                    ┌─────▼───────┐
                    │     End     │
                    └─────────────┘
```

FIG. 10

```
                    ┌──────────────┐
                    │    Start     │
                    └──────┬───────┘
                           │              ╭ S1010
          ┌────────────────▼────────────────┐
          │   Determine first SOC to be equal to │
          │      average SOC of battery groups    │
          └────────────────┬────────────────┘
                           │              ╭ S1020
          ┌────────────────▼────────────────┐     YES
          ◁     First SOC = Reference SOC?        ▷─────┐
          └────────────────┬────────────────┘          │
                        NO │    ╭ S1030                 │
          ┌────────────────▼────────────────┐          │
          │  Determine second SOC to be equal to maximum │
          │    SOC or minimum SOC of battery groups       │
          └────────────────┬────────────────┘          │
                           │   ╭ S1040                  │
    ┌ ─ ─ ─ ─ ─ ─ ─ ─ ─ ─ ─ ▼ ─ ─ ─ ─ ─ ─ ┐            │
          ┌──────────────────────────────┐  ╭ S1042     │
    │     │   Determine first weight and    │          │ │
          │ second weight based on second SOC│          │
    │     └────────────┬─────────────────┘          │ │
                       │   ╭ S1044                     │
    │     ┌────────────▼─────────────────┐          │ │   ╭ S1050
          │ Determine third SOC by applying first │      ┌──▼────────────┐
    │     │  weight and second weight to first SOC│   │  │ Third SOC = First SOC │
          │   and second SOC, respectively        │      └───────┬───────┘
    │     └──────────────────────────────┘          │ │         │
    └ ─ ─ ─ ─ ─ ─ ─ ─ ─ ┬ ─ ─ ─ ─ ─ ─ ─ ─ ┘            │
                        └──────────◄──────────────────────┘
                           │   ╭ S1060
    ┌ ─ ─ ─ ─ ─ ─ ─ ─ ─ ─ ─ ▼ ─ ─ ─ ─ ─ ─ ┐
          ┌──────────────────────────────┐  ╭ S1062
    │     │  Determine third weight and fourth weight │
          │ based on difference between third SOC │   │
    │     │   and previous SOC of battery bank    │
          └────────────┬─────────────────┘          │
    │                  │   ╭ S1064
          ┌────────────▼─────────────────┐          │
    │     │  Determine SOC of battery bank by applying │
          │ third weight and fourth weight to third SOC and│
    │     │  previous SOC of battery bank, respectively │
          └──────────────────────────────┘          │
    └ ─ ─ ─ ─ ─ ─ ─ ─ ─ ┬ ─ ─ ─ ─ ─ ─ ─ ─ ┘
                    ┌──────▼───────┐
                    │     End      │
                    └──────────────┘
```

FIG. 11

Start

S1110
Determine first SOC to be equal to
average SOC of battery groups

S1120
Second reference SOC ≤ First SOC
≤ First reference SOC? —— YES

NO

S1130
Determine second SOC to be equal to maximum
SOC or minimum SOC of battery groups

S1140

S1142
Determine first weight and
second weight based on second SOC

S1144
Determine third SOC by applying first weight
and second weight to first SOC
and second SOC, respectively

S1150
Third SOC = First SOC

S1160

S1162
Determine third weight and fourth weight
based on difference between third SOC
and previous SOC of battery bank

S1164
Determine SOC of battery bank by applying
third weight and fourth weight to third SOC
and previous SOC of battery bank, respectively

End

## INTERNATIONAL SEARCH REPORT

| International application No. |
|---|
| **PCT/KR2025/004102** |

| A. | CLASSIFICATION OF SUBJECT MATTER |
|---|---|

**G01R 31/382**(2019.01)i; **G01R 31/367**(2019.01)i; **G01R 31/396**(2019.01)i; **G01R 31/36**(2006.01)i

According to International Patent Classification (IPC) or to both national classification and IPC

| B. | FIELDS SEARCHED |
|---|---|

Minimum documentation searched (classification system followed by classification symbols)

G01R 31/382(2019.01); B60L 50/50(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전 상태(state of charge), 방전(discharge), 최대 (maximum), 가중치(weight), 평균(average)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2018-0058085 A (SAMSUNG ELECTRONICS CO., LTD.) 31 May 2018 (2018-05-31) <br> paragraph [0066]; and claims 1, 6-7, 9 | 1-15 |
| Y | KR 10-2016-0003817 A (NUVERA FUEL CELLS, LLC) 11 January 2016 (2016-01-11) <br> claims 1, 7 | 1-15 |
| Y | KR 10-2023-0054191 A (LG ENERGY SOLUTION, LTD.) 24 April 2023 (2023-04-24) <br> claim 2 | 9 |
| Y | KR 10-2021-0046407 A (LG CHEM, LTD.) 28 April 2021 (2021-04-28) <br> claim 1 | 10-12,14 |
| A | KR 10-2018-0037712 A (SAMSUNG ELECTRONICS CO., LTD.) 13 April 2018 (2018-04-13) <br> abstract | 1-15 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 July 2025** | **18 July 2025** |

| Name and mailing address of the ISA/KR | Authorized officer |
|---|---|
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/004102**

| Patent document cited in search report | | | Publication date (day/month/year) | Patent family member(s) | | | Publication date (day/month/year) |
|---|---|---|---|---|---|---|---|
| KR | 10-2018-0058085 | A | 31 May 2018 | KR | 10-2655790 | B1 | 09 April 2024 |
| | | | | US | 2018-0143258 | A1 | 24 May 2018 |
| KR | 10-2016-0003817 | A | 11 January 2016 | AU | 2014-260382 | A1 | 12 November 2015 |
| | | | | AU | 2014-260382 | B2 | 25 May 2017 |
| | | | | CA | 2911026 | A1 | 06 November 2014 |
| | | | | EP | 2991852 | A2 | 09 March 2016 |
| | | | | JP | 2016-528662 | A | 15 September 2016 |
| | | | | JP | 2018-160459 | A | 11 October 2018 |
| | | | | JP | 6333960 | B2 | 30 May 2018 |
| | | | | JP | 6653347 | B2 | 26 February 2020 |
| | | | | US | 2014-0324370 | A1 | 30 October 2014 |
| | | | | US | 9588184 | B2 | 07 March 2017 |
| | | | | WO | 2014-178994 | A2 | 06 November 2014 |
| | | | | WO | 2014-178994 | A3 | 08 January 2015 |
| KR | 10-2023-0054191 | A | 24 April 2023 | CN | 117223148 | A | 12 December 2023 |
| | | | | EP | 4318728 | A1 | 07 February 2024 |
| | | | | EP | 4318728 | A4 | 27 November 2024 |
| | | | | JP | 2024-518906 | A | 08 May 2024 |
| | | | | JP | 7674002 | B2 | 09 May 2025 |
| | | | | US | 2024-0219470 | A1 | 04 July 2024 |
| | | | | WO | 2023-063604 | A1 | 20 April 2023 |
| KR | 10-2021-0046407 | A | 28 April 2021 | CN | 113795760 | A | 14 December 2021 |
| | | | | CN | 113795760 | B | 17 May 2024 |
| | | | | EP | 3982137 | A1 | 13 April 2022 |
| | | | | EP | 3982137 | A4 | 03 August 2022 |
| | | | | EP | 3982137 | B1 | 31 January 2024 |
| | | | | ES | 2972493 | T3 | 13 June 2024 |
| | | | | HU | E065235 | T2 | 28 May 2024 |
| | | | | JP | 2022-523930 | A | 27 April 2022 |
| | | | | JP | 7302798 | B2 | 04 July 2023 |
| | | | | US | 12013440 | B2 | 18 June 2024 |
| | | | | US | 2022-0187382 | A1 | 16 June 2022 |
| | | | | WO | 2021-075771 | A1 | 22 April 2021 |
| KR | 10-2018-0037712 | A | 13 April 2018 | KR | 10-2579538 | B1 | 18 September 2023 |
| | | | | US | 10658858 | B2 | 19 May 2020 |
| | | | | US | 2018-0097370 | A1 | 05 April 2018 |
| | | | | US | 2020-0244074 | A1 | 30 July 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240047587
- KR 1020250039660